# EUROPÄISCHE PATENTSCHRIFT

(11) **EP 3 355 032 B1**
(45) Veröffentlichungstag und Bekanntmachung des Hinweises auf die Patenterteilung: **27.03.2019**
(21) Anmeldenummer: 17153762.4
(22) Anmeldetag: 30.01.2017
(51) Int. Cl.: G01D 5/20, H01L 21/00

(54) **SENSOR ZUR POSITIONSMESSUNG**
SENSOR FOR POSITION MEASUREMENT
CAPTEUR DE MESURE DE POSITION

(43) Veröffentlichungstag der Anmeldung: 01.08.2018
(73) Patentinhaber: Dr. Johannes Heidenhain GmbH, 83301 Traunreut (DE)
(72) Erfinder: RISSING, Lutz, 80337 München (DE); TIEMANN, Marc Oliver, 83329 Waging am See (DE); FRANK, Alexander, 83377 Vachendorf (DE)

(56) Entgegenhaltungen:
- US-A1- 2002 011 839
- US-A1- 2015 362 340
- US-B1- 6 313 624

## Beschreibung

Die Erfindung betrifft einen Sensor zur Positionsmessung beispielsweise für eine Winkel- beziehungsweise Längenmesseinrichtung gemäß dem Anspruch 1.

### GEBIET DER TECHNIK

Winkelmesseinrichtungen werden beispielsweise als Drehgeber zur Bestimmung der Winkellage zweier relativ zueinander drehbarer Maschinenteile verwendet. Darüber hinaus sind Längenmesseinrichtungen bekannt, bei denen eine lineare Verschiebung zweier relativ zueinander verschiebbarer Maschinenteile gemessen wird. Winkelmesseinrichtungen wie auch Längenmesseinrichtungen weisen üblicherweise Sensoren auf, die relativ zu den Sensoren bewegbare Bauteile, etwa Winkelskalierungen oder Längenskalierungen beziehungsweise Maßstäbe abtasten und positionsabhängige Signale erzeugen.

Bei induktiven Messeinrichtungen sind häufig Erregerleitungen und Empfängerleitungen etwa in Form von Leiterbahnen auf einer gemeinsamen Leiterplatte eines induktiven Sensors aufgebracht, der beispielsweise mit einem Stator eines Drehgebers fest verbunden ist. Dieser Leiterplatte gegenüber befindet sich eine Winkelskalierung, auf der in periodischen Abständen alternierend elektrisch leitfähige und nichtleitfähige Flächen oder Stege und Lücken als Teilungsstruktur aufgebracht sind: Die Winkelskalierung ist beispielsweise mit dem Rotor des Drehgebers drehfest verbunden. Wenn an den Erregerleitungen beziehungsweise Erregerspulen ein zeitlich wechselnder elektrischer Erregerstrom angelegt wird, werden in den Empfängerleitungen beziehungsweise -spulen während der Relativbewegung von der Position abhängige Signale erzeugt. Diese Signale werden dann in einer Auswerteelektronik des induktiven Sensors weiterverarbeitet.

Bei optischen Messeinrichtungen sind häufig Lichtquellen und Fotodetektoren auf einer Leiterplatte eines optischen Sensors montiert. Mit einem Luftspalt von der Leiterplatte gegenüber liegend befindet sich eine optische Skalierung. Nach bekannten Prinzipien können dann von der Position abhängige Signale erzeugt werden.

Häufig werden derartige Messeinrichtungen beziehungsweise Messgeräte für elektrische Antriebe, zur Bestimmung der Relativbewegung bzw. der Relativlage von entsprechenden Maschinenteilen, eingesetzt. In diesem Fall werden die erzeugten Positionswerte einer Folgeelektronik zur Ansteuerung der Antriebe über eine entsprechende Schnittstellenanordnung zugeführt.

### STAND DER TECHNIK

In der DE 103 07 674 A1 wird eine Winkelmesseinrichtung beschrieben, bei welcher der betreffende Sensor zwei sandwichartig zusammengefügten Leiterplatten aufweist.

Aus der US 2002 / 0011839 A1 ist eine Detektoreinheit bekannt, bei der auf einer Leiterplatte mit einem Verarbeitungsschaltkreis ein Metallfilm und ein Permeabilitätsfilm angeordnet sind und auf dem Permeabilitätsfilm ein Lesekopf.

Die US 6313624 B1 offenbart einen Positionssensor mit einem Mu-Metall-Schirm zwischen zwei Leiterplatten.

Gemäß der US 2015 / 0362340 A1 sind eine erste Leiterplatte und eine zweite Leiterplatte durch einen dünnen Metallfilm, z. B. aus Aluminium, voneinander getrennt. Auf diese Weise soll sichergestellt werden, dass von der Ansteuereinrichtung und der Auswerteinrichtung ausgehende Streufelder die Empfangsspannung beziehungsweise das Messergebnis nicht beeinflussen.

### ZUSAMMENFASSUNG DER ERFINDUNG

Der Erfindung liegt die Aufgabe zugrunde einen Sensor zu schaffen, der ein gegenüber äußeren Einflüssen robustes Betriebsverhalten ermöglicht und vergleichsweise wirtschaftlich herstellbar ist.

Diese Aufgabe wird erfindungsgemäß durch die Merkmale des Anspruches 1 gelöst.

Der Sensor zur Positionsmessung eines relativ zum Sensor bewegbaren Bauelements umfasst eine Leiterplatte und einen Metallkörper. Die Leiterplatte weist einen ersten Bereich auf, in dem ein Detektor angeordnet ist und einen zweiten Bereich, in dem elektronische Bauelemente angeordnet sind. Die Bauelemente sind elektrisch mit dem Detektor verbunden, insbesondere durch Leiterbahnen auf der Leiterplatte. Der Metallkörper ist zumindest zweilagig aufgebaut, wobei einer ersten Lage eine erste Fläche beziehungsweise Oberfläche zugeordnet werden kann und einer zweiten Lage eine zweite Fläche beziehungsweise Oberfläche. Dementsprechend weist der Metallkörper die erste Lage mit der ersten Fläche sowie die zweite Lage mit der zweiten Fläche auf. Der erste Bereich der Leiterplatte ist auf der ersten Fläche befestigt und der zweite Bereich der Leiterplatte ist auf der zweiten Fläche befestigt. Die erste Lage und die zweite Lage des Metallkörpers sind zwischen dem ersten Bereich der Leiterplatte und dem zweiten Bereich der Leiterplatte angeordnet, so dass der erste Bereich der Leiterplatte in einer ersten Ebene und der zweite Bereich der Leiterplatte in einer zweiten Ebene angeordnet sind.

In weiterer Ausgestaltung der Erfindung ist zwischen der ersten Lage und der zweiten Lage des Metallkörpers ein Klebespalt angeordnet, also ein Spalt, der mit Klebstoff ausgefüllt ist. Die Lagen des Metallkörpers sind folglich durch eine Klebefügung stoffschlüssig miteinander verbunden.

Alternativ können die Lagen des Metallkörpers miteinander verlötet sein, so dass insbesondere zwischen der ersten Lage und der zweiten Lage des Metallkörpers ein Lotmaterial angeordnet ist. Alternativ können die Lagen des Metallkörpers auch miteinander verschweißt sein.

Die Erfindung umfasst aber auch eine alternative Bauweise, bei der kein Klebespalt zwischen der ersten Lage und der zweiten Lage des Metallkörpers vorliegt und bei der die Lagen des Metallkörpers durch eine Umspritzung insbesondere mit einem Kunststoff oder mit einem Silikonwerkstoff zusammengehalten werden. Bei dieser Bauweise kann also der Metallkörper durch Faltung zusammen mit der Leiterplatte hergestellt werden und in diesem Zustand umspritzt werden.

Insbesondere weist die erste Lage des Metallkörpers eine dritte Fläche beziehungsweise Oberfläche auf und die zweite Lage des Metallkörpers weist eine vierte Fläche beziehungsweise Oberfläche auf. Die dritte Fläche und die vierte Fläche sind einander zugewandt angeordnet. Insbesondere sind die erste Fläche und die dritte Fläche der ersten Lage des Metallkörpers gegenüberliegend zueinander angeordnet. Ebenso sind die zweite Fläche und die vierte Fläche, die jeweils der zweiten Lage des Metallkörpers zugeordnet sind, gegenüberliegend zueinander angeordnet.

Sofern ein Klebespalt vorliegt, sind insbesondere die dritte Fläche und die vierte Fläche durch den Klebespalt voneinander beabstandet. Der Klebespalt ist also insbesondere zwischen der dritten Fläche und der vierten Fläche angeordnet.

Vorteilhafterweise sind die erste Fläche, die zweite Fläche, die dritte Fläche, und die vierte Fläche des Metallkörpers beziehungsweise der Lagen des Metallkörpers parallel zueinander angeordnet.

Mit Vorteil weist der Metallkörper weiterhin Befestigungsmittel zur mechanischen Befestigung des Sensors an einem Maschinenteil auf. Gemäß einer weiteren Ausgestaltung ist das Befestigungsmittel als eine Bohrung durch die erste Lage und / oder die zweite Lage des Metallkörpers ausgestaltet. Insbesondere kann der Metallkörper also nicht nur Träger der Leiterplatte sein, sondern gleichzeitig auch eine Flanschfunktion erfüllen. Beispielsweise können auskragende Laschen mit Bohrungen vorgesehen sein, die zur Befestigung des Sensors an einem Maschinenteil dienen.

Zwischen der ersten Lage und der zweiten Lage des Metallkörpers kann eine thermisch isolierende Schicht vorgesehen sein. Insbesondere bei dieser Bauweise kann nur die erste Lage oder nur die zweite Lage das Befestigungsmittel aufweisen. Wenn beispielsweise Komponenten im ersten Bereich der Leiterplatte relativ temperaturunempfindlich sind, so kann die erste Lage an einem vergleichsweise heißem Bauteil befestigt werden, wobei ein Wärmefluss zur zweiten Lage und damit auf möglicherweise temperaturempfindlichere Bauelemente auf dem zweiten Bereich der Leiterplatte durch die isolierende Schicht behindert werden kann.

Weiterhin kann der Metallkörper so ausgestaltet sein, dass dieser eine Kontur aufweist, die mechanisch bearbeitet ist und die als Referenz beziehungsweise Anschlag zum passgenauen Anbau an ein Maschinenteil verwendbar ist.

Mit Vorteil umfasst der Sensor ein Kabel mit einem Schirm, der elektrisch leitend mit dem Metallkörper verbunden ist. Somit kann der Metallkörper auch eine Masseanbindung des Sensors ermöglichen. Dabei kann beispielsweise der Schirm mit einer Schelle und einer Schraub- oder Nietverbindung mit dem Metallkörper verbunden sein.

Alternativ kann der Metallkörper beispielsweise so ausgestaltet sein, dass dieser ein an dem Metallkörper angeformtes Kontaktstück, beispielsweise ein Schellenband aufweist, welches im Zuge der Herstellung des Sensors mit dem Schirm verbunden wird, etwa durch Verpressen. Ein derartiges Schellenband kann als integraler Bestandteil des Metallköpers vorgesehen sein. Mit Vorteil ist das Kontaktstück an der zweiten Lage des Metallkörpers angeformt, insbesondere nur an der zweiten Lage, so dass in diesem Fall die erste Lage kein angeformtes Kontaktstück aufweist.

Vorteilhafterweise ist die Leiterplatte flexibel und einstückig ausgestaltet, wobei die Leiterplatte zudem einen gebogenen Verbindungssteg zwischen dem ersten Bereich und dem zweiten Bereich aufweist. Mit Vorteil ist die Leiterplatte mehrschichtig aufgebaut. Besonders vorteilhaft ist es, wenn die Leiterplatte Polyimid- oder Epoxy-Material umfasst. In vorteilhafter Ausgestaltung der Erfindung weist die Leiterplatte eine Dicke von weniger als 200 µm, insbesondere weniger als 120 µm auf, wobei hier insbesondere auf die Dicke des Substrats der Leiterplatte Bezug genommen wird und keinesfalls auf die Höhe der auf der Leiterplatte montierten Bauelemente.

In weiterer Ausgestaltung der Erfindung ist der Metallkörper einstückig ausgestaltet und weist einen flexiblen Steg auf, der gebogen verläuft und die erste Lage mit der zweiten Lage verbindet.

Mit Vorteil weist der Abschnitt des Metallkörpers, welcher zwischen dem ersten und dem zweiten Bereich der Leiterplatte angeordnet ist, eine Dicke von mehr als 0,5 mm, insbesondere mehr als 0,8 mm oder mehr als 1,0 mm auf. Mit anderen Worten ist insbesondere der Abstand zwischen dem ersten Bereich der Leiterplatte und dem zweiten Bereich der Leiterplatte gleich der Dicke des Metallkörpers in dem genannten Abschnitt. Weiterhin kann der Metallkörper so aufgebaut sein, dass die erste Lage und die zweite Lage jeweils die gleiche Dicke beziehungsweise Stärke aufweisen. Vorteilhafterweise weist der Metallkörper zwischen dem ersten und dem zweiten Bereich der Leiterplatte eine Dicke auf, welche mindestens 5 mal, insbesondere mindestens 8 mal oder mindestens 10 mal, größer ist als die Dicke der Leiterplatte beziehungsweise des Substrats der Leiterplatte. Der Metallkörper ist als starrer Körper ausgebildet und bildet einen mechanischen Träger für die dünne flexible Leiterplatte. Daher umfasst der Begriff Metallkörper im Folgenden keine flexible Metallfolie.

Der Sensor kann beispielsweise auch auf einem optischen Prinzip beruhen, so dass dann der Detektor in Form eine Fotodetektors beziehungsweise Fotodetektorarrays ausgebildet sein kann. Alternativ kann der Sensor auf einem magnetischen Prinzip beruhen, wobei dann der Detektor in Form eines oder mehrerer magnetoresistiven Elemente oder Hall-Elemente ausgebildet sein kann. Ebenso umfasst die Erfindung auch einen Sensor der auf einem kapazitiven Prinzip beruht. Mit Vorteil basiert der Sensor auf einem induktiven Messprinzip, wobei dann der Detektor in Form von Empfängerspulen ausgebildet sein kann. In diesem Fall kann der Sensor als induktiver Sensor bezeichnet werden.

Besonders wenn der Sensor auf einem induktiven Messprinzip beruht, ist es vorteilhaft wenn der Metallkörper aus einem ferromagnetischen, insbesondere weichmagnetischen, Stahl hergestellt ist. Alternativ kann beispielsweise auch Aluminium als Material für den Metallkörper verwendet werden.

Mit Vorteil sind bei einem Sensor, der auf einem induktiven Messprinzip beruht, im ersten Bereich der Leiterplatte Erregerspulen angeordnet. Insbesondere können dann im zweiten Bereich elektronische Bauelemente angeordnet sein, welche elektrisch mit den Erregerspulen verbunden sind, so dass die von den betreffenden Bauelementen erzeugten Erregerströme in die Erregerspulen übertragen werden können.

Durch die besondere Bauweise des Sensors ist ein Herstellungsverfahren anwendbar, bei dem zunächst eine Metalltafel mit dem Substrat einer flexiblen insbesondere mehrschichtigen Leiterplatte beschichtet beziehungsweise beklebt wird, so dass auf diese Weise die Leiterplatte auf der Oberfläche der Metalltafel befestigt ist. Mit Vorteil kann der Schichtaufbau der Leiterplatte auf der Metalltafel vorgenommen werden, so dass also keine vorgefertigten Leiterplatten mit Substrat und Leiterstrukturen verwendet werden. Vielmehr werden bei dieser Variante die erforderlichen (beispielsweise fotochemischen) Prozessschritte zum Aufbau der insbesondere mehrschichtigen Leiterplatte auf der Metalltafel vorgenommen.

Danach können einzelne Metallteile zusammen mit den Leiterplatten beziehungsweise dem Substrat abgetrennt werden. Nach einer Faltung und gegebenenfalls einer Klebung ist der Metallkörper hergestellt. Die elektronischen Bauelemente können beispielsweise vor der Faltung auf der Leiterplatte montiert werden und / oder nach der Faltung. Das Substrat der Leiterplatte kann als Bogen auf die Metalltafel aufgebracht werden und kann zusammen mit der Metalltafel abgetrennt beziehungsweise vereinzelt werden. Alternativ können auch einzelne Leiterplatten auf der Metalltafel befestigt beziehungsweise aufgeklebt werden, so dass die Metalltafel um diese herum geschnitten beziehungsweise abgetrennt wird.

Gemäß einem weiteren Aspekt umfasst die Erfindung eine Positionsmesseinrichtung, welche einen Sensor und ein relativ dazu bewegbares Bauteil mit einer Skalierung umfasst, wobei der Sensor zur Abtastung der Skalierung ausgebildet und bestimmt ist, so dass durch den Sensor Signale erzeugbar sind, welche eine Information über die relative Position zwischen dem Sensor und dem Bauteil beinhalten. Die Positionsmesseinrichtung kann als lineare Positionsmesseinrichtung zur Messung von relativen linearen Verschiebungen oder aber auch als Winkelmesseinrichtung zur Messung von relativen Winkellagen ausgestaltet sein.

Vorteilhafte Ausbildungen der Erfindung entnimmt man den abhängigen Ansprüchen.

Weitere Einzelheiten und Vorteile des erfindungsgemäßen Sensors ergeben sich aus der nachfolgenden Beschreibung von Ausführungsbeispielen anhand der beiliegenden Figuren.

### KURZE BESCHREIBUNG DER ZEICHNUNGEN

Es zeigen die
- Figur 1: eine Draufsicht auf den Sensor in einer frühen Montagephase,
- Figur 2: eine perspektivische Ansicht des Sensors,
- Figur 3: eine Schnittdarstellung eines Teilbereichs des Sensors
- Figur 4: eine perspektivische Teilansicht des Sensors,
- Figur 5: eine perspektivische Ansicht des Sensors mit montiertem Kabel,
- Figur 6: eine weitere perspektivische Ansicht des Sensors mit einem relativ dazu bewegbaren Bauteil,
- Figur 7: eine Draufsicht auf den Sensor gemäß einem zweiten Ausführungsbeispiel in der frühen Montagephase,
- Figur 8: eine perspektivische Teilansicht eines Metallkörpers für den Sensor gemäß einem dritten Ausführungsbeispiel,
- Figur 9: eine perspektivische Teilansicht des Metallkörpers für den Sensor gemäß dem dritten Ausführungsbeispiel mit montiertem Kabel.

### BESCHREIBUNG DER AUSFÜHRUNGSFORMEN

Im Zuge der Herstellung eines induktiven Sensors gemäß dem vorliegenden Ausführungsbeispiel wird zunächst eine Metalltafel, die im vorgestellten Ausführungsbeispiel eine Stärke beziehungsweise Dicke von 1,0 mm aufweist und aus weichmagnetischem Stahl (hier ein ferritischer Edelstahl) hergestellt ist, bereitgestellt. Auf dieser Metalltafel wird eine Vielzahl von flexiblen Leiterplatten 1 nach einem vorgegebenen Muster befestigt, insbesondere aufgeklebt. Jede der Leiterplatten 1 weist ein vergleichsweise dünnes Substrat (hier 0,1 mm) beispielsweise aus Polyimid, so dass diese an sich flexibel sind.

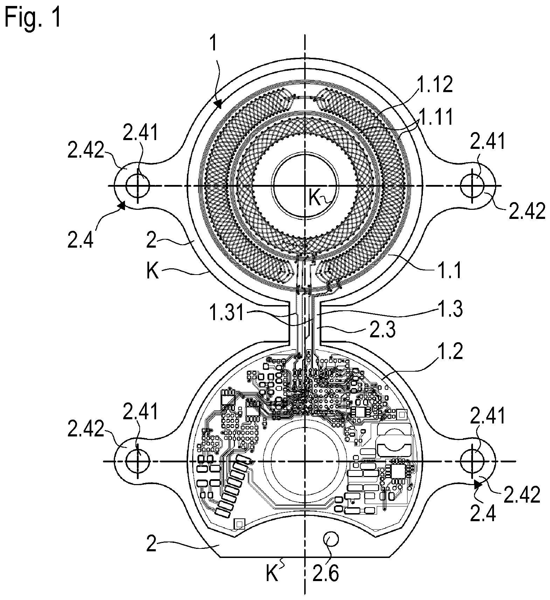

In der Figur 1 ist eine mehrschichtig aufgebaute flexible Leiterplatte 1 dargestellt. Diese ist einstückig und weist einen ersten Bereich 1.1 auf, der in erster Näherung ringförmig ausgestaltet ist. Weiterhin weist die Leiterplatte 1 einen zweiten Bereich 1.2 auf, der ebenfalls in erster Näherung ringförmig ausgestaltet ist. Zwischen dem ersten Bereich 1.1 und dem zweiten Bereich 1.2 weist die Leiterplatte 1 einen dritten Bereich 1.3 auf, der als Steg ausgestaltet ist und eine Verbindung zwischen dem ersten Bereich 1.1 und dem zweiten Bereich 1.2 darstellt.

Im Fertigungszustand gemäß der Figur 1 ist das Leiterbild der Leiterplatte 1 erkennbar. Demnach sind im ersten Bereich 1.1 so genannte Erregerspulen 1.11 und ein Detektor 1.12 in Form von Empfängerspulen vorgesehen, die als Leiterbahnen auf dem dünnen Substrat ausgebildet sind. Im vorgestellten Ausführungsbeispiel sind dem Detektor 1.12 beziehungsweise den Empfängerspulen zwei Spuren zugeordnet. Im zweiten Bereich 1.2 der Leiterplatte 1 sind Leiterbahnen und Pads dargestellt. Im dritten Bereich 1.3 der Leiterplatte 1 sind ebenfalls Leiterbahnen 1.31 aufgebracht, die zur elektrischen Verbindung der Komponenten im ersten Bereich 1.1 und denen im zweiten Bereich 1.2 der Leiterplatte 1 dienen.

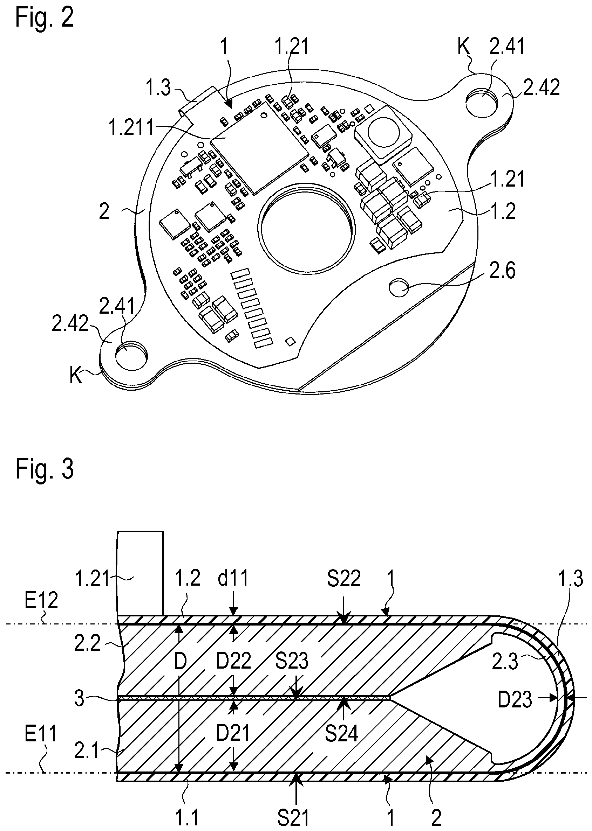

Nachdem die Vielzahl von flexiblen Leiterplatten 1 nach einem vorgegebenen Muster auf die Metalltafel aufgeklebt worden sind, wird in einem darauffolgenden Herstellungsschritt aus der Metalltafel ein Metallkörper 2 entlang der Kontur K herausgetrennt, beispielsweise durch einen Fräsprozess oder einen Laser- oder Wasserstrahlschneidprozess. Der Metallkörper 2 ist hier einteilig ausgestaltet, wobei ein Steg 2.3 des Metallkörpers 2 unter dem dritten Bereich 1.3 der Leiterplatte 1 angeordnet ist. Weiterhin werden Befestigungsmittel 2.4 in Form von Bohrungen 2.41 in Laschen 2.42 vorgesehen sowie eine Gewindebohrung 2.6. Zudem wird der Steg 2.3 des Metallkörpers 2 derart bearbeitet, dass dieser zumindest stellenweise eine reduzierte Dicke D23 (Figur 3) aufweist.

Als nächstes können nun auf dem zweiten Bereich 1.2 elektronische Bauelemente 1.21 montiert werden, zu denen im vorgestellten Ausführungsbeispiel auch ein ASIC-Baustein 1.211 gehört.

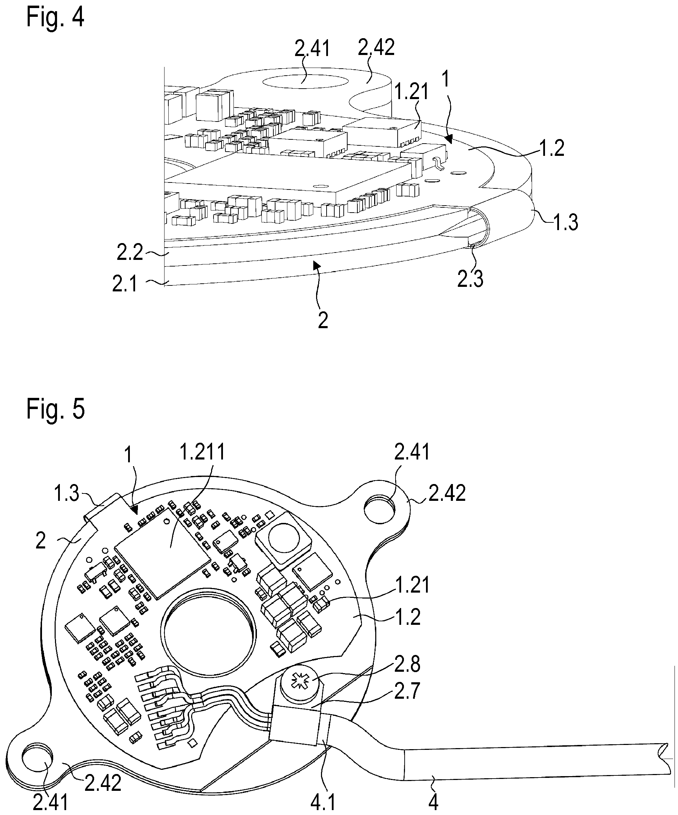

Danach wird auf die Unterseite des Metallkörpers 2 ein Kleber aufgetragen und die Leiterplatte 1 und der Metallkörper 2 werden gemeinsam so gefaltet, dass jeweils ein Paar der Bohrungen 2.41 übereinander zu liegen kommen (siehe Figur 2 oder Figur 4).

In der Figur 3 ist ein Teilschnitt durch den Sensor im Bereich des Stegs 2.3 des Metallkörpers 2 dargestellt. Demnach umfasst der Sensor einen gefalteten Metallkörper 2, der eine erste Lage 2.1 mit einer ersten Fläche S21 sowie eine zweite Lage 2.2 mit einer zweiten Fläche S22 aufweist. Der erste Bereich 1.1 der Leiterplatte 1 ist auf der ersten Fläche S21 und der zweite Bereich 1.2 der Leiterplatte 1 auf der zweiten Fläche S22 aufgeklebt. Die erste Lage 2.1 und die zweite Lage 2.2 des Metallkörpers 2 sind zwischen dem ersten Bereich 1.1 und dem zweiten Bereich 1.2 der Leiterplatte 1 angeordnet, so dass der erste Bereich 1.1 in einer ersten Ebene E11 und der zweite Bereich 1.2 in einer zweiten Ebene E12 angeordnet sind. Zwischen der ersten Lage 2.1 und die zweiten Lage 2.2 des Metallkörpers 2 befindet sich ein Klebespalt 3. Die erste Ebene E11 und die zweite Ebene E12 sind im vorgestellten Ausführungsbeispiel parallel zueinander angeordnet.

Außerdem weist die erste Lage 2.1 des Metallkörpers 2 eine dritte Fläche S23 auf und die zweite Lage 2.2 des Metallkörpers 2 weist eine vierte Fläche S24 auf. Die dritte Fläche S23 und die vierte Fläche S24 sind einander zugewandt angeordnet und durch den Klebespalt 3 voneinander beabstandet.

Dadurch, dass der Steg 2.3 des Metallkörpers 2 eine reduzierte Stärke D23 aufweist ist dieser flexibel, so dass der Metallkörper 2 zusammen mit der flexiblen Leiterplatte 1 beziehungsweise dem Steg 1.3 der Leiterplatte 1 problemlos gebogen werden kann. Im vorgestellten Ausführungsbeispiel ist die Stärke beziehungsweise Dicke D21 der ersten Lage 2.1 mit 1,0 mm genau so groß wie die Dicke D22 der zweiten Lage 2.2. Die Dicke D23 der dritten Lage 2.3 beträgt hier 0,1 mm. Die Leiterplatte 1 beziehungsweise das Substrat der Leiterplatte 1 weist hier eine Dicke d11 von 0,05 mm oder 50 µm auf. Nachdem der Klebespalt 3 etwa 0,05 mm dick ist, ergibt sich eine Gesamtdicke des Metallkörpers von etwa 2,05 mm, so dass also der Metallkörper 2 zwischen dem ersten und dem zweiten Bereich 1.1, 1.2 der Leiterplatte 1 eine Dicke D aufweist, welche etwa 41 mal größer ist als die Dicke d11 der Leiterplatte 1 beziehungsweise des Substrats der Leiterplatte 1.

Im weiteren Fortgang des Herstellungsprozesses wird ein mehradriges Kabel 4, das einen Schirm 4.1 (siehe Figur 5) aufweist, montiert. Zu diesem Zweck werden die Enden von Adern an dafür vorgesehenen Pads, die im zweiten Bereich 1.2 der Leiterplatte 1 angeordnet sind, kontaktiert, insbesondere verlötet. Des Weiteren wird eine Schelle 2.7 um den Schirm 4.1 gelegt und mit Hilfe der Gewindebohrung 2.6 und einer Schraube 2.8 am Metallkörper 2 befestigt. Somit ist nicht nur eine mechanische Verbindung zwischen dem Metallkörper 2 und dem Kabel 4 hergestellt, sondern auch eine elektrische Verbindung zwischen dem Metallkörper 2 und dem Schirm 4.1.

Der Sensor gemäß der Anordnung in Figur 2 kann nun beispielsweise mit elektrisch isolierendem Material umspritzt werden, so dass die elektronischen Bauelemente 1.21 sowie der Anschluss des Kabels 4 vor äußeren Einflüssen geschützt sind. Die Umspritzung kann in diesem Fall auch gleichzeitig als Zugentlastung für das Kabel 4 dienen.

Alternativ kann ein Umspritzen beziehungsweise ein Vergießen der elektronischen Bauelemente 1.21 auch schon vor dem Heraustrennen des Metallkörpers 2 aus der Metalltafel entlang der Kontur K vorgenommen werden um die elektronischen Bauelemente 1.21 schon in diesem Stadium vor äußeren Einflüssen zu schützen.

Der Sensor kann nun beispielsweise an einem Maschinenteil, etwa an einem Motorgehäuse, befestigt werden. Besonders vorteilhaft ist für diesen Zweck die Ausgestaltung des Metallkörpers 2 mit den Befestigungsmitteln 2.4 in Form von Bohrungen 2.41 in Laschen 2.42, die als Flansch wirken. Zudem kann die exakt bearbeitete Kontur K zumindest bereichsweise als Anschlagfläche dienen, so dass der Monteur des Sensors die Laschen 2.42 mit ihrer Kontur K lediglich an entsprechend vorbereiteten Flächen des Maschinenteils zum Anschlag bringen muss und anschließend durch die Bohrungen 2.41 Schrauben in Gewindebohrungen des Maschinenteil dreht. Auf diese Weise ist eine einfache und präzise Montage des Sensors möglich.

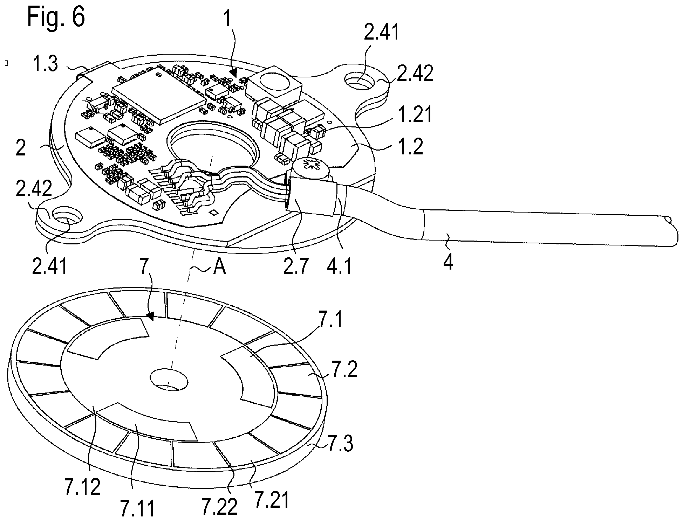

In der Figur 6 ist ein Prinzip-Bild eines Messsystems dargestellt, welches den erfindungsgemäßen Sensor und ein relativ dazu bewegbares (hier relativ zum Sensor drehbares) Bauteil 7 umfasst, das im vorgestellten Ausführungsbeispiel als eine Winkelskalierung ausgebildet ist. Das Bauteil 7 besteht aus einem Substrat 7.3, welches im dargestellten Ausführungsbeispiel aus Epoxydharz hergestellt ist, und auf welchem zwei Teilungsspuren 7.1, 7.2 angeordnet sind. Die Teilungsspuren 7.1, 7.2 sind kreisförmig ausgebildet und bezüglich einer Drehachse A konzentrisch mit unterschiedlichen Durchmessern auf dem Substrat 7.3 angeordnet. Die beiden Teilungsspuren 7.1, 7.2 bestehen jeweils aus einer periodischen Abfolge von alternierend angeordneten elektrisch leitfähigen Teilungsbereichen 7.11, 7.21 und nichtleitfähigen Teilungsbereichen 7.12, 7.22. Als Material für die elektrisch leitfähigen Teilungsbereiche 7.11, 7.21 wurde im gezeigten Beispiel Kupfer auf das Substrat 7.3 aufgebracht. In den nichtleitfähigen Teilungsbereichen 7.12, 7.22 wurde das Substrat 7.3 dagegen nicht beschichtet.

Die innere Teilungsspur 7.1 besteht in der dargestellten Ausführungsform aus drei Teilungsbereichen 7.11 mit elektrisch leitfähigem Material, sowie drei Teilungsbereichen 7.12, in denen kein leitfähiges Material angeordnet ist.

Radial benachbart zur ersten Teilungsspur 7.1 liegt die zweite Teilungsspur 7.2 auf dem Substrat 7.3, wobei auch die zweite Teilungsspur 7.2 aus einer Vielzahl elektrisch leitfähiger Teilungsbereiche 7.21 sowie dazwischen angeordneten nichtleitfähigen Teilungsbereichen 7.22 besteht. Die verschiedenen Teilungsbereiche 7.21, 7.22 sind materialmäßig dabei ebenso ausgebildet wie die Teilungsbereiche 7.11, 7.12 der ersten Teilungsspur 7.1. Insgesamt umfasst die zweite Teilungsspur 7.2 im dargestellten Ausführungsbeispiel sechzehn periodisch angeordnete, elektrisch leitfähige Teilungsbereiche 7.21 sowie entsprechend sechzehn dazwischen angeordnete nichtleitfähige Teilungsbereiche 7.22.

Üblicherweise dient das Bauteil 7 beziehungsweise die Winkelskalierung als Rotor und wird an einem um die Drehachse A drehbaren Maschinenteil befestigt. Dagegen bildet dann der Sensor den Stator der als Winkelmesseinrichtung ausgestalteten Positionsmesseinrichtung, so dass dieser an einem stehenden Maschinenteil fixiert wird. Im zusammengebauten Zustand der Positionsmesseinrichtung stehen sich das Bauteil 7 und der Sensor mit vergleichsweise geringem Luftspalt einander gegenüber, wobei der Luftspalt kleiner ist als in dem Prinzip-Bild der Figur 6 dargestellt. Die Drehachse A verläuft durch das Zentrum des Bauteils 7 beziehungsweise der Winkelskalierung, wobei bei einer Relativdrehung zwischen dem Bauteil 7 und dem Sensor in der Leiterplatte 1 ein von der jeweiligen Winkelstellung abhängiges Signal durch Induktionseffekte erzeugbar ist.

Der auf Leiterplatte 1 montierte ASIC-Baustein 1.211 arbeitet nicht nur als Auswerteelement, sondern auch als Erregerkontrollelement, unter dessen Kontrolle der Erregerstrom, welcher dann durch die Erregerspulen 1.11 fließt, erzeugt wird. Durch den Erregerstrom werden im Detektor 1.12 Spannungen in Abhängigkeit von der Winkelstellung des Bauteils 7 beziehungsweise der Winkelskalierung induziert, wobei diese Spannungen beziehungsweise Signale durch Bauelemente 1.21, die im zweiten Bereich 1.2 der Leiterplatte 1 montiert sind verstärkt, demoduliert und in digitale Signale gewandelt werden. In logischen Schaltungen auf dem Digitalteil des ASIC-Bausteins 1.211 werden die Positionswerte resultierend aus der Abtastung der einzelnen Teilungsspuren 7.1, 7.2 ermittelt, bzw. berechnet. Die Positionswerte können über das Kabel 4 an eine Folgeelektronik, beispielsweise eine Numerische Steuerung einer Maschine, übertragen werden. Eine mit dem Sensor ausgestattete Winkelmesseinrichtung dient demnach zur Erfassung einer Winkelposition zwischen dem Sensor, der an einem Maschinenteil festlegbar ist und dem Bauteil 7 mit der Winkelskalierung, das an einem zweiten Maschinenteil, etwa einer Welle, festlegbar ist.

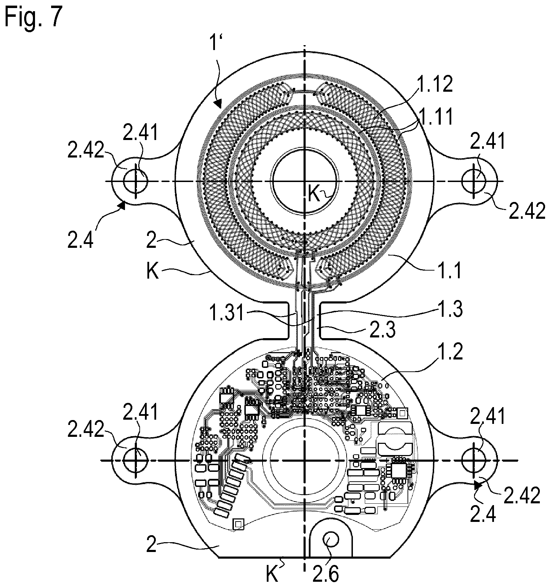

Anhand der Figur 7 wird eine alternative Ausgestaltung des Sensors beschrieben. Bei dieser Variante wird eine mehrschichtige Leiterplatte 1' auf der Metalltafel aufgebaut. Dementsprechend wird der mehrschichtige Aufbau der Leiterplatte 1' hier unmittelbar auf der Metalltafel vorgenommen. Bei der Variante gemäß der Figur 7 wird die Leiterplatte 1' mit einem Substrat aus Polyimid unter Verwendung eines fotochemischen beziehungsweise eines dünnfilmtechnischen Prozesses aufgebaut, wobei die Befestigungsmittel 2.4 beziehungsweise die Laschen 2.42 unbeschichtet bleiben sowie ein Bereich um die als Schirmanbindung dienende Gewindebohrung 2.6.

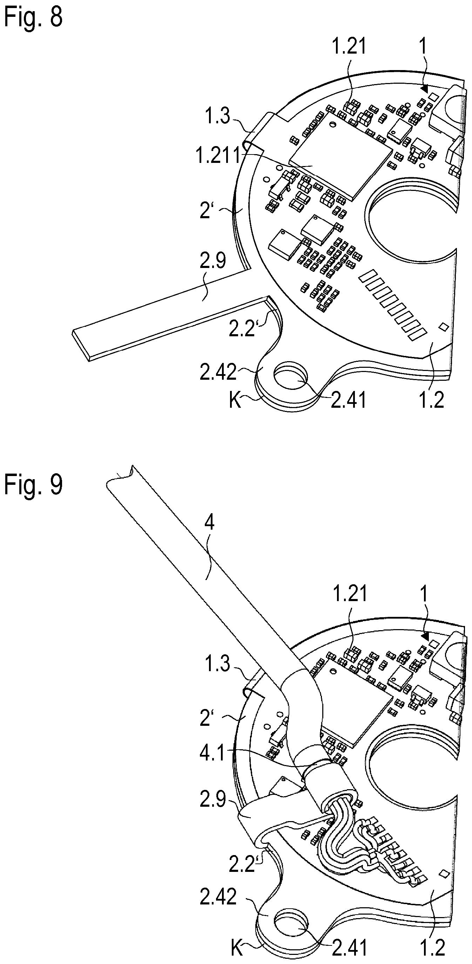

Anhand der Figuren 8 und 9 wird eine weitere alternative Ausgestaltung der Erfindung erläutert, bei der am Metallkörper 2' ein Kontaktstück 2.9 als integraler Bestandteil des Metallköpers 2' angeformt ist. Im vorgestellten Ausführungsbeispiel ist das Kontaktstück 2.9 nur an der zweiten Lage 2.2' des Metallkörpers 2' angeformt. In der Figur 8 ist der betreffende Metallkörper 2' in einer Herstellungsphase vor der Kontaktierung mit dem Schirm 4.1 des Kabels 4 gezeigt. Das Kontaktstück 2.9 ist als Band beziehungsweise Schellenband ausgestaltet, welches durch Verpressen unter plastischer Verformung mit dem Schirm 4.1 gemäß der Figur 9 verbunden ist, so dass eine sichere elektrische Kontaktierung des Schirms 4.1 mit dem Metallkörper 2' hergestellt ist. Üblicherweise wird von einigen elektronischen Bauelementen 1.21 im Betrieb des Sensors Wärme erzeugt. Durch den besonderen Aufbau des Sensors ist es möglich die Betriebstemperatur bei gegebener Wärmeerzeugung vergleichsweise niedrig zu halten. Der Grund hierfür liegt darin, dass die erzeugte Wärme durch den Metallkörper 2, 2' mit relativ wenig Wärmeleitwiderstand abfließen kann und insbesondere über die Laschen 2.42 beispielsweise an das Maschinenteil abgegeben werden kann.

Zudem wird durch die vorgestellte Bauweise ein Sensor bereitgestellt, der bezüglich Einflüssen von äußeren elektromagnetischen Feldern unempfindlich ist, weil der Metallkörper 2, welcher insbesondere mit dem Schirm 4.1 des Kabels 4 elektrisch verbunden ist, selbst abschirmend wirkt.

## Patentansprüche

1. Sensor zur Positionsmessung eines relativ zum Sensor bewegbaren Bauteils (7), wobei der Sensor eine Leiterplatte (1; 1') und einen Metallkörper (2; 2') aufweist, wobei
die Leiterplatte (1; 1')
• einen ersten Bereich (1.1) aufweist, in dem ein Detektor (1.12) angeordnet ist, und
• einen zweiten Bereich (1.2) aufweist, in dem elektronische Bauelemente (1.21) angeordnet sind, welche elektrisch mit dem Detektor (1.12) verbunden sind,
der Metallkörper (2; 2')
• eine erste Lage (2.1) mit einer ersten Fläche (S21) sowie
• eine zweite Lage (2.2, 2.2') mit einer zweiten Fläche (S22) aufweist, wobei
der erste Bereich (1.1) der Leiterplatte (1; 1') auf der ersten Fläche (S21) befestigt ist und der zweite Bereich (1.2) der Leiterplatte (1; 1') auf der zweiten Fläche (S22) befestigt ist, wobei die erste Lage (2.1) und die zweite Lage (2.2, 2.2') des Metallkörpers (2; 2') zwischen dem ersten Bereich (1.1) und dem zweiten Bereich (1.2) der Leiterplatte (1; 1') angeordnet sind, so dass der erste Bereich (1.1) in einer ersten Ebene (E11) und der zweite Bereich (1.2) in einer zweiten Ebene (E12) angeordnet sind, wobei der Metallkörper (2; 2') einstückig ausgestaltet ist und einen flexiblen Steg (2.3) aufweist, der gebogen verläuft und die erste Lage (2.1) mit der zweiten Lage (2.2, 2.2') verbindet.

2. Sensor gemäß dem Anspruch 1, wobei zwischen der ersten Lage (2.1) und der zweiten Lage (2.2, 2.2') des Metallkörpers (2; 2') ein Klebespalt (3) angeordnet ist.

3. Sensor gemäß einem der vorhergehenden Ansprüche, wobei der Metallkörper (2; 2') weiterhin Befestigungsmittel (2.4) zur mechanischen Befestigung des Sensors an einem Maschinenteil aufweist.

4. Sensor gemäß dem Anspruch 3, wobei das Befestigungsmittel (2.4) als eine Bohrung (2.41) durch die erste Lage (2.1) und / oder die zweite Lage (2.2, 2.2') des Metallkörpers (2; 2') ausgestaltet ist.

5. Sensor gemäß einem der vorhergehenden Ansprüche, wobei der Metallkörper (2; 2') eine Kontur (K) aufweist, die mechanisch bearbeitet ist und als Referenz zum passgenauen Anbau an ein Maschinenteil verwendbar ist.

6. Sensor gemäß einem der vorhergehenden Ansprüche, wobei der Sensor ein Kabel (4) mit einem Schirm (4.1) umfasst und der Schirm (4.1) elektrisch leitend mit dem Metallkörper (2; 2') verbunden ist.

7. Sensor gemäß dem Anspruch 6, wobei am Metallkörper (2') ein Kontaktstück (2.9) als integraler Bestandteil des Metallköpers (2') angeformt ist, welches mit dem Schirm (4.1) durch Verpressen verbunden ist.

8. Sensor gemäß einem der vorhergehenden Ansprüche, wobei die Leiterplatte (1; 1') flexibel und einstückig ausgestaltet ist und einen gebogenen Verbindungssteg (1.3) zwischen dem ersten Bereich (1.1) und dem zweiten Bereich (1.2) aufweist.

9. Sensor gemäß einem der vorhergehenden Ansprüche, wobei der Metallkörper eine Dicke von mehr als 0,5 mm aufweist.

10. Sensor gemäß einem der vorhergehenden Ansprüche, wobei die erste Lage (2.1) des Metallkörpers (2; 2') eine dritte Fläche (S23) aufweist und die zweite Lage (2.2, 2.2') des Metallkörpers (2; 2') eine vierte Fläche (S24) aufweist, wobei die dritte Fläche (S23) und die vierte Fläche (S24) einander zugewandt angeordnet sind.

11. Sensor gemäß einem der vorhergehenden Ansprüche, wobei die erste Lage (2.1) des Metallkörpers (2; 2') eine dritte Fläche (S23) aufweist und die zweite Lage (2.2, 2.2') des Metallkörpers (2; 2') eine vierte Fläche (S24) aufweist, wobei die erste Fläche (S21), die zweite Fläche (S22), die dritte Fläche (S23) und die vierte Fläche (S24) parallel zueinander angeordnet sind.

12. Sensor gemäß einem der vorhergehenden Ansprüche, wobei der Sensor auf einem induktiven Messprinzip basiert und der Detektor in Form von Empfängerspulen (1.12) ausgebildet ist.

13. Sensor gemäß einem der vorhergehenden Ansprüche, wobei der Metallkörper (2; 2') aus weichmagnetischem Stahl hergestellt ist.

14. Sensor gemäß einem der Ansprüche 12 oder 13, wobei im ersten Bereich (1.1) der Leiterplatte (1; 1') Erregerspulen (1.11) angeordnet sind.

15. Sensor gemäß dem Anspruch 14, wobei im zweiten Bereich (1.2) elektronische Bauelemente (1.21) angeordnet sind, welche elektrisch mit den Erregerspulen (1.11) verbunden sind.

## Claims

1. Sensor for position measurement of a device (7) movable relative to the sensor, the sensor having a printed circuit board (1; 1') and a metal body (2; 2'), wherein
the printed circuit board (1; 1')
has a first region (1.1), in which a detector (1.12) is arranged, and
a second region (1.2), in which there are arranged electronic components (1.21), which are connected electrically to the detector (1.12),
the metal body (2; 2')
has a first layer (2.1) with a first surface (S21) and
a second layer (2.2, 2.2') with a second surface (S22), wherein
the first region (1.1) of the printed circuit board (1; 1') is fixed to the first surface (S21) and the second region (1.2) of the printed circuit board (1; 1') is fixed to the second surface (S22), wherein
the first layer (2.1) and the second layer (2.2, 2.2') of the metal body (2; 2') are arranged between the first region (1.1) and the second region (1.2) of the printed circuit board (1; 1'), so that the first region (1.1) is arranged in a first plane (E11) and the second region (1.2) is arranged in a second plane (E12), wherein the metal body (2; 2') is configured in one piece and has a flexible web (2.3), which runs in a curve and connects the first layer (2.1) to the second layer (2.2, 2.2').

2. Sensor according to Claim 1, wherein an adhesive gap (3) is arranged between the first layer (2.1) and the second layer (2.2, 2.2') of the metal body (2; 2').

3. Sensor according to one of the preceding claims, wherein the metal body (2; 2') also has fixing means (2.4) for the mechanical fixing of the sensor to a machine part.

4. Sensor according to Claim 3, wherein the fixing means (2.4) is configured as a hole (2.41) through the first layer (2.1) and/or the second layer (2.2, 2.2') of the metal body (2; 2').

5. Sensor according to one of the preceding claims, wherein the metal body (2; 2') has a contour (K) which is mechanically machined and can be used as a reference for the accurately fitting attachment to a machine part.

6. Sensor according to one of the preceding claims, wherein the sensor comprises a cable (4) with a sheath (4.1), and the sheath (4.1) is electrically conductively connected to the metal body (2, 2').

7. Sensor according to Claim 6, wherein a contact piece (2.9) is moulded onto the metal body (2') as an integral constituent part of the metal body (2'), which is connected to the sheath (4.1) by pressing.

8. Sensor according to one of the preceding claims, wherein the printed circuit board (1; 1') is flexible and configured in one piece and has a curved connecting web (1.3) between the first region (1.1) and the second region (1.2).

9. Sensor according to one of the preceding claims, wherein the metal body has a thickness of more than 0.5 mm.

10. Sensor according to one of the preceding claims, wherein the first layer (2.1) of the metal body (2; 2') has a third surface (S23), and the second layer (2.2, 2.2') of the metal body (2; 2') has a fourth surface (S24), wherein the third surface (S23) and the fourth surface (S24) are arranged facing each other.

11. Sensor according to one of the preceding claims, wherein the first layer (2.1) of the metal body (2; 2') has a third surface (S23), and the second layer (2.2, 2.2') of the metal body (2; 2') has a fourth surface (S24), wherein the first surface (S21), the second surface (S22), the third surface (S23) and the fourth surface (S24) are arranged parallel to one another.

12. Sensor according to one of the preceding claims, wherein the sensor is based on an inductive measuring principle and the detector is constructed in the form of receiver coils (1.12),

13. Sensor according to one of the preceding claims, wherein the metal body (2; 2') is produced from soft magnetic steel.

14. Sensor according to either of Claims 12 and 13, wherein exciter coils (1.11) are arranged in the first region (1.1) of the printed circuit board (1; 1').

15. Sensor according to Claim 14, wherein electronic components (1.21) which are connected electrically to the exciter coils (1.11) are arranged in the second region (1.2).

## Revendications

1. capteur destiné à la mesure de position d'un élément structural (7) pouvant être déplacé par rapport au capteur, le capteur possédant un circuit imprimé (1 ; 1') et un corps métallique (2 ; 2'),
le circuit imprimé (1 ; 1')
- possédant une première zone (1.1) dans laquelle est disposé un détecteur (1.12) et
- possédant une deuxième zone (1.2) dans laquelle sont disposés des composants électroniques (1.21) qui sont reliés électriquement au détecteur (1.12),
le corps métallique (2 ; 2')
- possédant une première couche (2.1) ayant une première surface (S21) ainsi
- qu'une deuxième couche (2.2, 2.2') ayant une deuxième surface (S22),
la première zone (1.1) du circuit imprimé (1 ; 1') étant fixée sur la première surface (S21) et la deuxième zone (1.2) du circuit imprimé (1 ; 1') étant fixée sur la deuxième surface (S22),
la première couche (2.1) et la deuxième couche (2.2, 2.2') du corps métallique (2 ; 2') étant disposées entre la première zone (1.1) et la deuxième zone (1.2) du circuit imprimé (1 ; 1'), de sorte que la première zone (1.1) est disposée dans un premier plan (E11) et la deuxième zone (1.2) dans un deuxième plan (E12), le corps métallique (2 ; 2') étant réalisé d'une seule pièce et possédant un élément jointif flexible (2.3) qui s'étend de manière courbe et relie la première couche (2.1) à la deuxième couche (2.2, 2.2').

2. Capteur selon la revendication 1, un joint de collage (3) étant disposé entre la première couche (2.1) couche (2.2, 2.2') du corps métallique (2 ; 2').

3. Capteur selon l'une des revendications précédentes, le corps métallique (2 ; 2') possédant en outre des moyens de fixation (2.4) destinés à la fixation mécanique du capteur à une partie de machine.

4. Capteur selon la revendication 3, le moyen de fixation (2.4) étant réalisé sous la forme d'un perçage (2.41) à travers la première couche (2.1) et/ou la deuxième couche (2.2, 2.2') du corps métallique (2 ; 2').

5. Capteur selon l'une des revendications précédentes, le corps métallique (2 ; 2') possédant un contour (K) qui est usiné mécaniquement et qui peut être utilisé comme référence pour un montage avec ajustement précis sur une partie de machine.

6. Capteur selon l'une des revendications précédentes, le capteur comprenant un câble (4) muni d'un blindage (4.1) et le blindage (4.1) étant relié de façon électriquement conductrice au corps métallique (2 ; 2').

7. Capteur selon la revendication 6, une pièce de contact (2.9) qui fait partie intégrante du corps métallique (2) étant façonnée sur le corps métallique (2'), laquelle est reliée au blindage (4.1) par pressage.

8. Capteur selon l'une des revendications précédentes, le circuit imprimé (1 ; 1') étant de configuration flexible et d'un seul tenant et possédant un élément de jonction (1.3) courbe entre la première zone (1.1) et la deuxième zone (1.2).

9. Capteur selon l'une des revendications précédentes, le corps métallique présentant une épaisseur supérieure à 0,5 mm.

10. Capteur selon l'une des revendications précédentes, la première couche (2.1) du corps métallique (2 ; 2') possédant une troisième surface (S23) et la deuxième couche (2.2, 2.2') du corps métallique (2 ; 2') possédant une quatrième surface (S24), la troisième surface (S23) et la quatrième surface (S24) étant disposées de manière à se faire mutuellement face.

11. Capteur selon l'une des revendications précédentes, la première couche (2.1) du corps métallique (2 ; 2') possédant une troisième surface (S23) et la deuxième couche (2.2, 2.2') du corps métallique (2 ; 2') possédant une quatrième surface (S24), la première surface (S21), la deuxième surface (S22), la troisième surface (S23) et la quatrième surface (S24) étant disposées en parallèle les unes des autres.

12. Capteur selon l'une des revendications précédentes, le capteur se basant sur un principe de mesure inductif et le détecteur étant réalisé sous la forme de bobines réceptrices (1.12).

13. Capteur selon l'une des revendications précédentes, le corps métallique (2 ; 2') étant fabriqué en acier magnétique doux.

14. Capteur selon l'une des revendications 12 ou 13, des bobines d'excitation (1.11) étant disposées dans la première zone (1.1) du circuit imprimé (1 ; 1').

15. Capteur selon la revendication 14, des composants électroniques (1.21) qui sont reliés électriquement aux bobines d'excitation (1.11) étant disposés dans la deuxième zone (1.2).
